# EUROPÄISCHE PATENTSCHRIFT

(11) **EP 2 809 475 B1**
(45) Veröffentlichungstag und Bekanntmachung des Hinweises auf die Patenterteilung: **28.09.2016**
(21) Anmeldenummer: 13704739.5
(22) Anmeldetag: 01.02.2013
(51) Int. Cl.: B23K 26/00, B23K 26/36, B23K 26/40, B30B 15/06, B44C 1/22, B41N 1/04

(54) **VERFAHREN ZUM ERZEUGEN VON ÄTZFÄHIGEN STRUKTUREN UNTER VERWENDUNG EINES LASERS MIT EINER WELLENLÄNGE IM INFRAROTBEREICH**
METHOD OF PRODUCING ETCHABLE STRUCTURES USING A LASER HAVING A WAVELENGTH IN THE INFRARED RANGE
PROCÉDÉ DE RÉALISATION DE STRUCTURES APTES À LA GRAVURE EN UTILISANT UN LASER AYANT UNE LONGUEUR D'ONDE DANS LE DOMAINE INFRAROUGE

(30) Priorität: 03.02.2012 DE 102012100915
(43) Veröffentlichungstag der Anmeldung: 10.12.2014
(73) Patentinhaber: Sandvik Surface Solutions Division of Sandvik Materials Technology Deutschland GmbH, 58256 Ennepetal (DE)
(72) Erfinder: NIGGEMANN, Ralf, 58566 Kierspe (DE); PEUSTER, Heiko, 42399 Wuppertal-Beyenburg (DE)
(74) Vertreter: Lenzing Gerber Stute
(86) Internationale Anmeldenummer: PCT/EP2013/052087
(87) Internationale Veröffentlichungsnummer: WO 2013/113901

(56) Entgegenhaltungen:
- DE-A1- 19 544 272
- DE-C2- 4 033 230
- US-A- 4 015 221
- US-A1- 2002 043 522

## Beschreibung

Die Erfindung betrifft ein Verfahren zum Erzeugen von ätzresistenten Strukturen (Masken) auf den Oberflächen von metallischen Presswerkzeugen, nämlich Endlospressbändern oder Pressblechen, mittels eines Lasers, wobei eine zu strukturierende Oberfläche des Presswerkzeugs mit einem thermosensitiven, ätzresistenten Überzug versehen wird und der Laser Strukturen aus dem ätzresistenten Überzug ausbrennt.

Oberflächenstrukturierte großformatige Endlospressbänder und Pressbleche dienen dazu, Platten- oder Bandmaterial zu dekorativen oder technischen Zwecken mit einer Oberflächenstruktur zu versehen. Oberflächenstrukturiertes Platten- oder Bandmaterial wird beispielsweise in der Möbel-, Fußboden-, Bau- und Nutzfahrzeugindustrie ( z.B. Böden für Ladeflächen) verwendet.

Das Plattenmaterial wird beispielsweise aus diversen Kunststoffen hergestellt. Ebenso kommen Span-, Sperrholz- und MDF-Platten zur Anwendung, die mit durch Melaminharz getränkten Filmen / Papieren / Dekoren auf der Nutzseite (Oberseite) oder der Unterseite beschichtet werden. Bei der Produktion von Fußböden oder Nutzfahrzeugböden ebenso wie bei Bauplatten wird dem Melaminfilm / -papier auf der Nutzfläche zusätzlich noch ein definierter Anteil von Korundmaterialien beigegeben, um der Plattennutzfläche die erforderliche Abriebfestigkeit zu verleihen. Für dekorative Anwendungen werden die Oberflächen der Platten mit dekorativen Strukturen, wie beispielsweise Holz-, Stein- oder anderen Strukturen (perlförmige, fein streifige Oberflächenstrukturen, etc.) versehen. Platten für die Bau- und Nutzfahrzeugindustrie erhalten beispielsweise technischgeometrische Strukturen, wie Rauten, Näpfchen oder Riffelungen (um beispielsweise Rutschfestigkeit zu bewirken).

Bei der Herstellung des Plattenmaterials kommen Doppelband- und Heizpressen zum Einsatz. In den Heizpressen werden Einzelbleche oder kassettierte Blechstapel eingesetzt. In den Pressen werden die Prägnate (zu prägende Platten) unter definiertem Druck und Temperatur verpresst.

Die Herstellung von den genannten Presswerkzeugen erfolgt durch Auftragen einer strukturierten, ätzresistenten Maske auf die zu strukturierende Oberfläche des Pressblechs oder Endlospressbandes und nachfolgendes Ätzen der maskierten Oberfläche. Die ätzresistente Maske wird üblicherweise auf die Oberfläche aufgedruckt. Nach dem Ätzen wird die Maske mechanisch oder elektrolytisch entfernt und die Oberfläche gereinigt. Dieser Vorgang wird so oft mit verschiedenen Strukturen wiederholt, bis die gewünschte Endstruktur erreicht wurde. In der Regel wird dann die strukturierte Oberfläche des Werkzeugs verchromt. Dadurch wird seine Lebensdauer erhöht, ein definierter Glanzgrad der herzustellenden Plattenoberfläche eingestellt und ein leichteres Entformen der Platte (Ablösen des Pressblechs von der Platte) nach dem Verpressen ermöglicht. Die Struktur der Oberfläche des Presswerkzeugs entspricht dann dem Negativ der auf dem Plattenmaterial zu erzeugenden Oberflächenstruktur.

Das Aufdrucken der ätzresistenten Maske erfolgt üblicherweise mit einer Druckwalze. Ein Nachteil herkömmlicher Druckverfahren besteht darin, dass der Druckvorgang unpräzise ist. Die mit der Druckwalze aufgebrachte Farbe verläuft geringfügig, so dass Abweichungen in der Maske gegenüber der graphisch (oft digital) erstellten Maskenvorlage nicht zu 100% vermieden werden können. Auf einer bereits geätzten Struktur verstärkt sich dieser ungünstige Einfluss umso mehr, da die Struktur- / Konturflanken ein geringes Ablaufen der Druckfarbe bewirken. Ein anderer Nachteil besteht darin, dass die Druckwalze die Maske bei bereits geätzten Oberflächen (besonders bei tiefen Ätzungen) aufgrund tiefer, teilweise sehr enger Strukturelemente nicht zu 100% übertragen kann. In Folge dessen fehlt teilweise in den Strukturtälern Druckfarbe. Die Maske wird deshalb dort nur unvollständig abgebildet und kann im nachfolgenden Ätzvorgang dem entsprechend nur unvollständig in die Oberfläche geätzt werden. Weitere Nachteile bestehen darin, dass nicht rapportfrei bedruckt werden kann, dass das Druckbild nicht definiert und synchron zum später produzierten Dekor platziert werden kann und dass Trocknungszeiten des Mediums berücksichtigt werden müssen.

Eine Maske kann auch durch Aufbringen eines Fotolackes erzeugt werden. Dies erfolgt indem der auf das Presswerkzeug aufgebrachte Fotolack mit einem Film, der die gewünschte Strukturaussage darstellt, abgedeckt und belichtet wird. Dabei härten die belichteten (oder die nicht belichteten) Teile des Fotolackes (positiv / negativ - Fotoresistlack) aus. Nach der Belichtung werden die nicht ausgehärteten Teile chemisch von der Werkzeugoberfläche gelöst. Es verbleibt eine strukturierte Maske auf dem Werkzeug. Die Werkzeugoberfläche wird dann geätzt. Anschließend erfolgt eine Reinigung und ggf. ein nochmaliges Aufbringen einer anderen Maske mit anschließender nochmaliger Ätzung. Dieser Vorgang wird so lange mit verschiedenen Masken wiederholt bis die gewünschte Endstruktur in der Oberfläche des Presswerkzeugs erreicht wurde. Auch das fototechnische Verfahren weist wesentliche Nachteile auf. So besteht bei großen Presswerkzeugoberflächen ein Problem darin, dass ein Film aus mehreren Filmstücken zusammengesetzt und geklebt werden muss, da keine ausreichend großformatigen Filme zur Verfügung stehen. An den Klebekanten entstehen bei der Entwicklung des Fotolackes unerwünschte Irritationen, die vor dem Ätzen aufwändig manuell korrigiert werden müssen. Des Weiteren belasten die Fotochemikalien Mitarbeiter und Umwelt. Darüber hinaus ist die Beschaffung und Entsorgung des Fotolackes aufwändig und teuer. Schließlich ist das Verfahren arbeitsintensiver als ein herkömmliches Druckverfahren, da zusätzliche Arbeitsgänge erforderlich sind (belichten, auswaschen des nicht ausgehärteten Fotolackes). Im Übrigen ist das fototechnische Verfahren für Endlospressbänder technisch und wirtschaftlich nicht anwendbar.

Aus dem nächstliegenden Stand der Technik DE 40 33 230 C2 (Basis für den Oberbegriff des Anspruchs 1) ist ein Verfahren der eingangs genannten Art zum Aufprägen von Prägegravuren auf großformatige Pressplatten oder Endlosbänder für die Oberflächenbehandlung von Bahnen oder Platten aus Kunststoff bekannt, bei dem das Pressblech oder Endlosband zunächst mit einer vollflächigen Trägerbahn aus Kunststoff, einer galvanischen Metallschicht oder einem ätzfesten Farbfilm überzogen wird. Mit Laserstrahlen wird dann eine nur die Dicke des Überzugs erfassende Prägestruktur erzeugt. Anschließend werden die metallblanken Stellen der Pressplatten und/oder der Endlosbänder einer Ätzbehandlung unterzogen.

Bisher sind Laserverfahren zur Herstellung ätzfähiger Masken für die industrielle Fertigung von Endlospressbändern oder Pressblechen noch nicht zur Anwendung gekommen. Dies könnte daran liegen, dass die digitale Darstellung einer Maske auf Großformaten ein Problem darstellt. Bei großformatigen Pressblechen von beispielsweise mehr als 8 m² wird das auf dem Pressblech aufzubringende Strukturbild in verschiedene Felder, sogenannte Kacheln, unterteilt, deren Strukturbild nacheinander auf das Pressblech aufgebracht werden. Hiermit bleiben die zu verarbeitenden Datenmengen des Strukturbildes für die Steuerung des Laserkopfes handhabbar. Damit ein einheitliches Strukturbild entsteht, überlappen sich die einzelnen Kacheln. Ein Nachteil dieser Verfahrensweise ist aber, dass in den sich überlappenden Kachelbereichen unerwünschte, sichtbare Kanten in der Struktur der mit dem Laser ausgebrannten Maske entstehen. Des Weiteren sind aufgrund der Lasertechnologie die ausgebrannten Kanten der Struktur unsauber, es fehlt die erforderliche Kantenschärfe. Außerdem verbleiben auf der Werkzeugoberfläche nach dem Ätzen sichtbare Irritationen in der Struktur, die das Strukturbild nicht mehr verkaufsfähig machen.

Somit besteht ein der Erfindung zugrunde liegendes Problem darin, ein geeignetes Verfahren der eingangs genannten Art zur Verfügung zu stellen, bei dem die genannten Probleme nicht oder zumindest deutlich reduziert auftreten.

Diese Aufgabe wird mit einem Verfahren mit den Merkmalen des Anspruchs 1 gelöst.

Es wurde überraschend festgestellt, dass das Auftreten von Kanteneffekten auf dem bearbeiteten Presswerkzeug vermieden werden können, wenn der Überzug mit einem Laser, der mit einer Wellenlänge im Infrarotbereich zwischen 780 nm und 1 mm emittiert, ausgebrannt wird. Dies könnte daran liegen, dass ein Laserstrahl mit einer Wellenlänge im Infrarotbereich nur sehr gering in eine metallische Oberfläche einkoppelt und zu einem sehr hohen Grad (75% oder mehr) reflektiert wird. Gegenüber anderen, insbesondere im UV-Bereich arbeitenden Lasern, wird damit wenig Wärme in der Oberfläche des Presswerkzeugs dissipiert. Somit kann der Laser zwar effektiv eine Struktur aus dem ätzresistenten Überzug ausbrennen, wobei er gleichzeitig die Eigenschaften der metallischen Oberfläche des Presswerkzeugs unbeeinflusst lässt.

Als besonderes geeignet haben sich CO₂-Laser herausgestellt, die einen Laserstrahl mit einer Wellenlänge von 10,6 µm erzeugen.

Auch haben sich Laserstrahlen eines YAG-Lasers mit Wellenlängen von 1064 nm, 946 nm, 1320 nm oder 1444 nm als für das erfindungsgemäße Verfahren geeignet erwiesen.

Das erfindungsgemäße Verfahren ist besonders geeignet zum Erzeugen von ätzresistenten Strukturen auf großformatigen Pressblechen mit einer Breite und einer Länge von jeweils mehr als 1 m, wobei das Pressblech auf einem Tisch, insbesondere einem Vakuumtisch, gelagert wird, und der Laser oberhalb des Pressblechs relativ zum Pressblech beweglich ist. Dabei sind wahlweise der Tisch und/oder der Laserkopf mindestens in zwei Richtungen verfahrbar. Das erfindungsgemäße Verfahren ist insbesondere auch für sehr große Pressbleche mit einer strukturierten Oberfläche einer Größe von 6 m² oder mehr oder auch 8 m² und darüber geeignet.

Natürlich kann das erfindungsgemäße Verfahren auch für ein Endlospressband eingesetzt werden, wobei dann das Endlospressband an einem in einer Richtung verfahrbaren Laser vorbeigeführt wird.

Bei beiden Anwendungen ist der Laserkopf bzw. der Laser typischerweise in seiner Höhe gegenüber dem Presswerkzeug verstellbar und steuerbar. Wenn der Laserstrahl vorzugsweise mittels einer Linse fokussiert ist, kann dann der Fokus des Laserstrahls für ein optimales Ausbrennen des Überzugs genau positioniert werden.

Gerade bei großformatigen Pressblechen ist es sinnvoll und bei derzeitiger Steuerungstechnik sogar notwendig, dass der Laser den Überzug in verschiedenen Abschnitten, die insbesondere kachelartig sind, bearbeitet. In diesem Fall ist es besonders bevorzugt, wenn ein den Laser tragender Kopf über einem Abschnitt positioniert wird und der Laser zeilenweise die Struktur aus dem Überzug ausbrennt, und wobei die Kontur der in den Überzug eingebrachten Struktur am Ende der Bearbeitung mit dem Laserstrahl umfahren wird.

Zum Ausbrennen des Überzugs wird der Laser vorzugsweise im Pulsbetrieb betrieben, wobei die einzelnen Pulse so gesetzt werden, dass sich nebeneinander liegende ausgebrannten Punkte ebenso wie die Punkte benachbarter Zeilen überlappen. Bei einem ausreichend leistungsfähigen Laser kann das Ausbrennen auch im Continuous-Wave-Betrieb erfolgen.

Am Ende des erfindungsgemäßen Verfahrens ist es sinnvoll, das Presswerkzeug nach dem Ausbrennen des Überzugs mit einem Lösungsmittel zu reinigen, insbesondere mit einem Alkohol, vorzugsweise mit Ethanol, wobei das Ethanol mit 1% 2-Butanon vergällt sein kann.

Bei einer möglichen Variante zur Vorbereitung des Laserausbrennverfahrens wird das mit einem ätzresistenten Überzug versehene Presswerkzeug gegenüber dem Laser ausgerichtet.

Dies geschieht für ein Pressblech beispielsweise wie folgt: Das Pressblech wird auf einen Vakuumtisch gelegt und grob zu in Längsrichtung des Tisches angeordneten Führungen für einen Support ausgerichtet. Der Support trägt einen Laser, wobei der Laser quer zu den Supportführungen am Support beweglich gelagert und motorisch angetrieben ist. Nach erfolgter grober Ausrichtung wird das Vakuum aktiviert, so dass das Pressblech fixiert ist und eben auf dem Vakuumtisch liegt.

Der Tisch kann unabhängig von den Supportführungen 2-dimensional in der Horizontalen bewegt werden. Zur Feinausrichtung des Pressblechs gegenüber den Supportführungen werden auf dem Pressblech zwei gegenüber liegende Referenzpunkte markiert, die von dem Laser angefahren werden können. Dazu wird zunächst ein erster Referenzpunkt auf dem Pressblech angefahren und die Position in der Steuerung des Laserkopfes als solcher gespeichert. Dann wird der Laser über die lange Tischseite zum gegenüberliegenden Referenzpunkt bewegt. Der Tisch wird so verschoben, dass der Laser bei seiner Bewegung in Richtung der Supportführungen den zweiten Referenzpunkt trifft. Auch diese Position wird in der Steuerung des Laserkopfes gespeichert. Dann wird der Laser wieder zum ersten Referenzpunkt zurückbewegt. Sollte sich die Lage des ersten Referenzpunktes durch das Verschieben des Tisches verschoben haben, kann die gesamte Prozedur solange wiederholt werden, bis dass mit der Lasersteuerung die Referenzpunkte genau angefahren werden können. Alternativ hierzu kann der erste Referenzpunkt von der Steuerung des Laserkopfes erneut angefahren werden, ohne dass der Tisch noch einmal ausgerichtet wird, wobei aufgrund des dadurch bestimmbaren Versatzes zwischen der ursprünglichen Lage des ersten Referenzpunktes und der dann aktuellen Lage des Referenzpunktes von der Steuerung des Laserkopfes oder eines Rechners zur Vorgabe des Strukturbildes die Lage des Strukturbildes bzw. seiner Kacheln auf dem Pressblech berechnet werden kann.

Zur Vorbereitung eines mit einem ätzresistenten Überzug versehenen Endlospressband wird das Band in einem Ständerwerk zwischen zwei gegenüberliegenden Trommeln positioniert. Das Ständerwerk ist konstruktiv so ausgelegt, dass ein 100%iger Gradeauslauf des Bandes möglich ist. Gegenüber einer der Trommeln wird die Laserstrahlquelle angebracht. Die Positionierung des Lasers erfolgt so, dass der Laserstrahl radial zur Trommel verläuft. Dadurch wird ein konturscharfes Ausbrennen der Struktur möglich.

Die Wegesteuerung für den Laser zum erfindungsgemäßen Ausbrennen des Überzugs auf einem Pressblech kann beispielsweise kachelweise erfolgen. Hierfür wird der Laser in eine Position über einem gedachten quadratischen oder rechteckigen Kachelabschnitt auf dem Pressblech bewegt, vorzugsweise in eine Position lotrecht oberhalb des Mittelpunktes der Kachel. Von diesem Punkt aus brennt der Laser zeilenweise die gewünschte Struktur aus dem Überzug aus. Hierfür ist der Laser im Support verschwenkbar gelagert. Nachdem der Laser alle Zeilen der Kachel abgefahren und den Überzug an den gewünschten Stellen entfernt hat, wird er vorzugsweise noch einmal entlang der Konturen der auszubrennenden Strukturen entlang gefahren, um der ausgebrannten Struktur eine glatte Kontur zu verleihen. Danach wird der Laser in eine Position über einer weiteren Kachel bewegt. Von dort brennt er dann die Struktur in den Überzug dieser gedachten Kachel ein.

Das kachelweise Bearbeiten des Überzugs ist insbesondere der Möglichkeiten der Ansteuerung eines Lasers geschuldet. Es ist ebenso denkbar, den Laser zeilenweise über die gesamte Breite (oder Länge) des Pressblechs verfahren zu lassen, wenn der Support des Lasers eine entsprechend fehlerfreie Führung des Lasers zulässt. Diese Verfahrensweise hat dann den Vorteil, dass auf eine verschwenkbare Lagerung des Lasers verzichtet werden kann und der Laserstrahl immer lotrecht auf das beschichtete Pressblech auftrifft. Man kann auch dann auf eine verschwenkbare Lagerung des Lasers verzichten, wenn der Laser innerhalb des Supports in zwei Richtungen parallel zur Oberfläche des Pressblechs verfahren werden kann, so dass der Laserstrahl innerhalb einer Kachel zeilenweise verfahrbar ist und er immer Lotrecht auf das Pressblech auftrifft. Somit lässt sich die auszubrennende Struktur besonders scharf konturieren.

Die Wegesteuerung des Lasers beim Ausbrennen des Überzugs auf einem Endlospressband erfolgt zum einen quer zum Band, wobei das Band nach jeder Überfahrt des Lasers um einen Zeilenvorschub weiter transportiert wird. In diesem Fall wird das Band von den Trommeln intermittierend angetrieben. Das Band kann aber auch längs zum Laser verfahren werden, wobei nach jedem Umlauf des Lasers ein Zeilenvorschub des Lasers in Querrichtung erfolgt. Als weitere Möglichkeit kann das Ausbrennen auch spiralförmig erfolgen. Dabei wird der Laser bei einem spiralförmigen Ausbrennen des Überzugs so gesteuert, dass eine lückenlos ausgebrannte Maske entsteht.

Wie sich aus dem Vorstehenden ergibt, ist das erfindungsgemäße Verfahren als Teil eines Verfahrens zum Erzeugen einer strukturierten Oberfläche eines Pressblechs oder Pressbandes gedacht. Dabei wird das Pressblech, nachdem es erfindungsgemäß mit einer ätzresistenten Struktur versehen worden ist, geätzt, um eine Oberflächenstruktur auf dem Pressblech oder Pressband zu erzeugen. Nachfolgend wird die ätzresistente Struktur von der Oberfläche entfernt. Diese Verfahrensschritte können nach Bedarf zum Erzeugen einer komplexeren Oberflächenstruktur des Pressblechs wiederholt werden, wobei insbesondere die Ätztiefen der einzelnen Ätzschritte variiert werden.

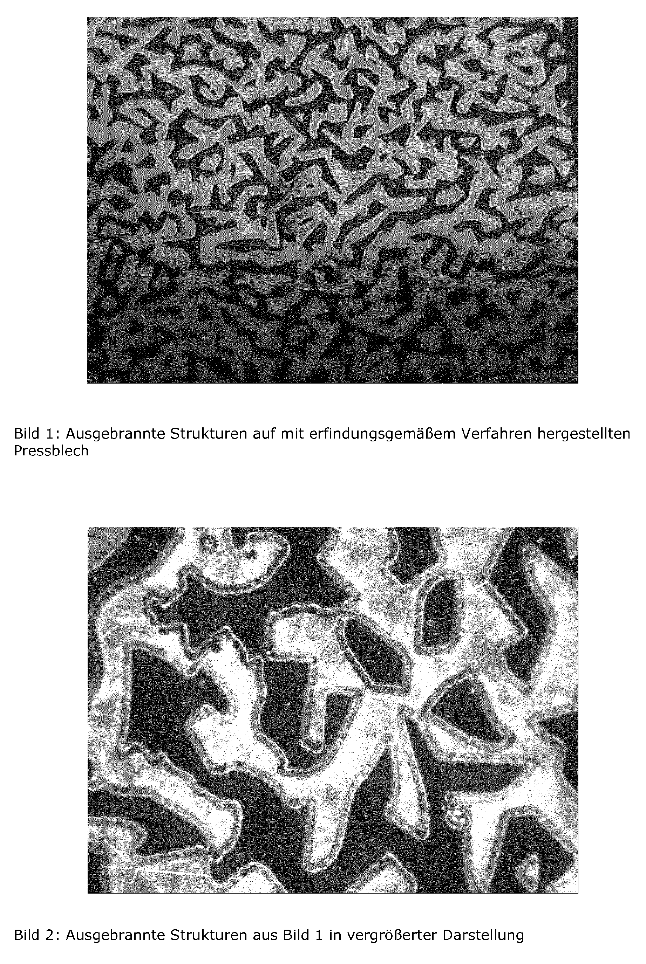

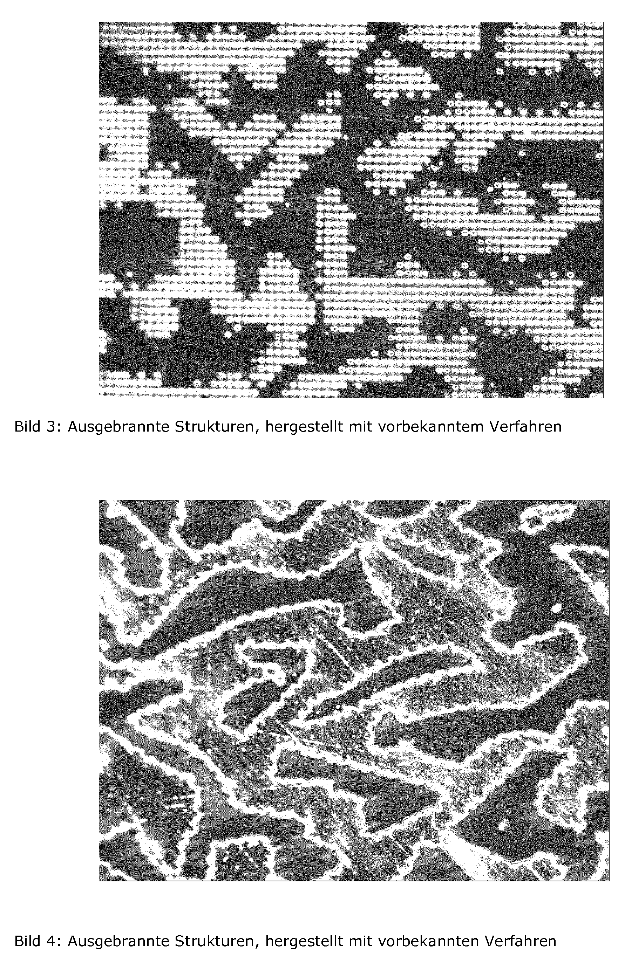

Die nachfolgenden Bilder 1 und 2 zeigen das Ergebnis des Laserausbrennens mit dem erfindungsgemäßen Verfahren, bei dem die Konturen des Überzugs mit dem Laser nachgefahren wurde. Die Bilder 3 und 4 zeigen das Ergebnis eines Laserausbrennverfahrens, bei dem die Konturen der auszubrennenden Konturen nicht nachgefahren wurden. In den Bildern 1 und 2 ist gegenüber den Bildern 3 und 4 deutlich zu erkennen, dass die herausgebrannten Strukturen glatte Ränder und damit eine klare Kontur haben. Demgegenüber sind die Konturen in den Strukturen, die mit herkömmlichen Laserausbrennverfahren hergestellt wurden und in den Bildern 3 und 4 gezeigt sind, ausgefranst.

## Patentansprüche

1. Verfahren zum Erzeugen von ätzresistenten Strukturen (Masken) auf den Oberflächen von metallischen Presswerkzeugen, nämlich Endlospressbändern oder Pressblechen, mittels eines Lasers, wobei eine zu strukturierende Oberfläche des Presswerkzeugs mit einem thermosensitiven, ätzresistenten Überzug versehen wird und der Laser Strukturen aus dem ätzresistenten Überzug ausbrennt, **dadurch gekennzeichnet, dass** die Struktur mit einem Laser ausgebrannt wird, der Licht mit einer Wellenlänge im Infrarotbereich zwischen 780 nm und 1 mm emittiert.

2. Verfahren nach Anspruch 1, **dadurch gekennzeichnet, dass** der Laser ein CO₂-Laser mit einer Wellenlänge von 10,6 µm ist.

3. Verfahren nach Anspruch 1, **dadurch gekennzeichnet, dass** der Laser ein YAG-Laser ist und mit einer Wellenlänge von 1064 nm, 946 nm, 1320 nm oder 1444 nm emittiert.

4. Verfahren nach einem der Ansprüche 1 bis 3, **dadurch gekennzeichnet, dass** das Presswerkzeug ein großformatiges Pressblech mit einer Breite und einer Länge von jeweils mehr als 1 m ist, dass das Pressblech auf einem Tisch, insbesondere einem Vakuumtisch, gelagert wird, und dass der Laser oberhalb des Pressblechs relativ zum Pressblech beweglich ist.

5. Verfahren nach einem der Ansprüche 1 bis 4, **dadurch gekennzeichnet, dass** der Laser den Überzug in verschiedenen Abschnitten, die insbesondere kachelartig sind, bearbeitet, wobei ein den Laser tragender Kopf über einem Abschnitt positioniert wird und der Laser zeilenweise die Struktur aus dem Überzug ausbrennt, und wobei die Kontur der in den Überzug eingebrachten Struktur am Ende der Bearbeitung mit dem Laserstrahl umfahren wird.

6. Verfahren nach einem der Ansprüche 1 bis 5, **dadurch gekennzeichnet, dass** der Laser zum Ausbrennen im Pulsbetrieb betrieben wird, wobei die einzelnen Pulse so gesetzt werden, dass sich nebeneinander liegende ausgebrannten Punkte ebenso wie die Punkte benachbarter Zeilen überlappen.

7. Verfahren nach einem der Ansprüche 1 bis 6, **dadurch gekennzeichnet, dass** das Presswerkzeug nach dem Ausbrennen des Überzugs mit einem Lösungsmittel, insbesondere mit einem Alkohol, vorzugsweise mit Ethanol, wobei das Ethanol mit 1% 2-Butanon vergällt sein kann, gereinigt wird.

8. Verfahren zum Erzeugen einer strukturierten Oberfläche eines Pressblechs oder Pressbandes mit den folgenden Verfahrensschritten:
a. Erzeugen einer ätzresistenten Struktur mit einem Verfahren gemäß einem der Ansprüche 1 bis 7,
b. Ätzen der mit der ätzresistenten Struktur versehenen Oberfläche, und
c. Entfernen der ätzresistenten Struktur von der Oberfläche,
wobei die Schritte a. bis c. nach Bedarf zum Erzeugen einer komplexeren Oberflächenstruktur des Pressblechs wiederholt werden.

## Claims

1. Method for producing etch-resistant structures (masks) on the surfaces of metallic pressing tools, specifically continuous press belts or press plates, by means of a laser, wherein a surface of the pressing tool to be structured is provided with a thermo-sensitive, etch-resistant coating and the laser burns structures out of the etch-resistant coating, **characterised in that** the structure is burnt out with a laser which emits light having a wavelength in the infrared range between 780 nm and 1mm.

2. Method according to claim 1, **characterised in that** the laser is a CO₂ laser having a wave length of 10.6 µm.

3. Method according to claim 1, **characterised in that** the laser is a YAG laser and emits with a wavelength of 1064 nm, 946 nm, 1320 nm or 1444 nm.

4. Method according to one of claims 1 to 3, **characterised in that** the pressing tool is a large press plate having a width and a length of more than 1 m respectively, that the press plate is mounted on a table, in particular a vacuum table, and that the laser is moveable above the press plate relative to the press plate.

5. Method according to one of claims 1 to 4, **characterised in that** the laser processes the coating in different sections, which are, in particular, tile-shaped, wherein a head bearing the laser is positioned over a section and the laser burns the structure out of the coating line by line, and wherein the contour of the structure introduced into the coating is driven around with the laser beam at the end of the processing.

6. Method according to one of claims 1 to 5, **characterised in that** the laser is operated to burn out in pulsed operation, wherein the individual pulses are set such that burnt-out points lying next to one another, as well as the points of neighbouring lines, overlap.

7. Method according to one of claims 1 to 6, **characterised in that** the pressing tool is cleaned, after the burning-out of the coating, with a solvent, in particular with alcohol, preferably with ethanol, wherein the ethanol can be denatured with 1% 2-butanone.

8. Method for producing a structured surface of a press plate or press belt having the following method steps:
a. producing an etch-resistant structure with a method according to one of claims 1 to 7,
b. etching the surface provided with the etch-resistant structure, and
c. removing the etch-resistant structure from the surface,
wherein steps a. to c. are repeated according to need to produce a complex surface structure of the press plate.

## Revendications

1. Procédé de réalisation de structures résistantes à la gravure (masques) sur les surfaces d'outils d'emboutissage métalliques, en l'occurrence des feuillards continus ou des tôles embouties, au moyen d'un laser, une surface à structurer de l'outil d'emboutissage étant pourvue d'un revêtement thermosensible résistant à la gravure et le laser réalisant par brûlage des structures dans le revêtement résistant à la gravure, **caractérisé en ce que** la structure est réalisée par brûlage au moyen d'un laser émettant une lumière d'une longueur d'onde comprise entre 780 nm et 1 mm dans la plage infrarouge.

2. Procédé selon la revendication 1, **caractérisé en ce que** le laser est un laser au CO₂ ayant une longueur d'onde de 10,6 µm.

3. Procédé selon la revendication 1, **caractérisé en ce que** le laser est un laser YAG qui émet à une longueur d'onde de 1 064 nm, 946 nm, 1 320 nm ou 1 444 nm.

4. Procédé selon l'une des revendications 1 à 3, **caractérisé en ce que** l'outil d'emboutissage est une tôle emboutie de grand format avec une largeur et une longueur respectivement supérieures à 1 m, **en ce que** la tôle emboutie est rangée sur une table, en particulier une table à dépression, et **en ce que** le laser est déplaçable par rapport à la tôle emboutie au-dessus de la tôle emboutie.

5. Procédé selon l'une des revendications 1 à 4, **caractérisé en ce que** le laser usine le revêtement par sections différentes, en particulier en mosaïque, une tête supportant le laser étant positionnée au-dessus d'une section et le laser brûlant linéairement la structure dans le revêtement, et la périphérie de la structure appliquée dans le revêtement étant contournée à la fin de l'usinage par le faisceau laser.

6. Procédé selon l'une des revendications 1 à 5, **caractérisé en ce que** le laser est mis en service en mode à impulsions pour le brûlage, les différentes impulsions étant fixées de telle manière que des points brûlés situés côte à côte se chevauchent tout comme les points de lignes contiguës.

7. Procédé selon l'une des revendications 1 à 6, **caractérisé en ce qu'**après le brûlage du revêtement, l'outil d'emboutissage est nettoyé avec un solvant, en particulier avec un alcool, préférentiellement avec de l'éthanol, l'éthanol pouvant être avec dénaturé par 1 % de 2-butanone.

8. Procédé de réalisation d'une surface structurée d'un feuillard ou d'une tôle emboutie, comprenant les étapes suivantes .
a. réalisation d'une structure résistante à la gravure au moyen d'un procédé selon l'une des revendications 1 à 7,
b. gravure de la surface pourvue de la structure résistante à la gravure, et
c. retrait de la surface de la structure résistante à la gravure,
les étapes a. à c. étant répétées pour réaliser une structure de surface de la tôle emboutie plus complexe si nécessaire.
